# EUROPÄISCHE PATENTSCHRIFT

(11) **EP 3 501 041 B1**
(45) Veröffentlichungstag und Bekanntmachung des Hinweises auf die Patenterteilung: **26.01.2022**
(21) Anmeldenummer: 16775115.5
(22) Anmeldetag: 20.09.2016
(51) Int. Cl.: H01L 23/32, H01L 23/40, H01L 23/00, H01L 25/11

(54) **WELLPLATTE FÜR EINE SPANNANORDNUNG FÜR HALBLEITERELEMENT UND SPANNANORDNUNG**
CORRUGATED PANEL FOR A CLAMPING ARRANGEMENT FOR A SEMICONDUCTOR ELEMENT AND CLAMPING ARRANGEMENT
PLAQUE ONDULÉE DESTINÉE À UN DISPOSITIF DE SERRAGE POUR ÉLÉMENT SEMI-CONDUCTEUR ET DISPOSITIF DE SERRAGE

(43) Veröffentlichungstag der Anmeldung: 26.06.2019
(73) Patentinhaber: Siemens Energy Global GmbH & Co. KG, 81739 München (DE)
(72) Erfinder: BÖHM, Matthias, 91564 Neuendettelsau (DE); SCHMITT, Daniel, 92353 Postbauer-Heng (DE)
(86) Internationale Anmeldenummer: PCT/EP2016/072255
(87) Internationale Veröffentlichungsnummer: WO 2018/054447

(56) Entgegenhaltungen:
- EP-A2- 2 172 971
- WO-A1-2016/074727
- US-A1- 2006 219 396

## Beschreibung

Die Erfindung betrifft eine Wellplatte für eine Spannanordnung gemäß Anspruch 1 sowie eine Spannanordnung gemäß Anspruch 8.

Eine solche Spannanordnung findet beispielsweise in der Hochspannungstechnik Anwendung. Dort werden insbesondere Halbleiter-Bauelemente miteinander verspannt, um eine möglichst gute elektrische Kontaktierung zwischen ihnen zu erreichen. Bekannte Spannanordnungen sind meist über mechanische Elemente verspannt, beispielsweise geeignete Gewindesysteme. Die Druckkraftübertragung auf die Anordnung der Bauelemente erfolgt meist punktuell mit einem oder mehreren Schraubelementen und wird dann über Druckstücke großflächig verteilt, so dass die Bauelemente im Spannverband verpresst werden.

Im Beitrag "4.5kV Press Pack IGBT Designed for Ruggedness and Reliability" von S. Eicher et al., IAS Seattle 2004, ist ein IGBT-Modul (ein sogenanntes Press Pack-Modul) mit parallel angeordneten IGBT-Chipeinheiten beschrieben, die in einem gemeinsamen Gehäuse aufgenommen sind. Das Gehäuse weist eine sich über mehrere Chipeinheiten erstreckende obere und eine untere leitende Platte auf, die die von einer gemeinsamen Spannvorrichtung erzeugte mechanische Kraft auf die Chipeinheiten überträgt. Jede Chipeinheit bildet eine Anordnung von stapelweise übereinander liegenden Bauelementen. Jeder der die Chipeinheit bildenden Anordnungen ist dabei eine einzelne Tellerfeder zugeordnet, so dass die Kraftübertragung auf die IGBT-Chips jeweils mittels der einzelnen Tellerfeder erfolgt. Die Druckverteilung auf den gepressten Flächen der einzelnen Chipeinheiten mittels der jeweiligen Tellerfeder ist allerdings relativ inhomogen.

Mit steigender Fläche der verpressten Bauelemente gewinnt die Homogenität der Verteilung der Druckkraft jedoch an Bedeutung. Werden zudem dünne und spröde Bauelemente, wie beispielsweise Halbleiter-Chips, verwendet, so ist eine homogene Verteilung der Druckkraft von entscheidender Bedeutung. Inhomogenitäten können in solchen Fällen zu einer Beschädigung und einem Ausfall der Bauelemente führen.

WO2016074727 A1 offenbart eine Spannanordnung zum Verspannen von Halbleiterbauelementen mit einem Druckstück zum Übertragen einer mechanischen Druckkraft auf einen Halbleiterbauelement. Dem Druckstück ist ein Druckverteilungskörper mit einer Zellstruktur zugeordnet, wobei die Zellwände unterschiedliche Zellwandstärken und/oder die Zellhohlräume unterschiedliche Volumina aufweisen.

Ferner ist aus der Druckschrift WO2016/000775 eine Spannanordnung mit einer Federplatte bekannt. Die Federplatte weist eine Vielzahl von nebeneinander angeordneten und miteinander verbundenen Tellerfederelementen auf, wobei die Tellerfederelemente vom Mittelpunkt der Federplatte nach außen hin eine Druckkraft stärker abfedern. Hierdurch wird eine vergleichsweise gleichmäßigere Druckkraftübertragung der Spannanordnung erreicht.

Die Aufgabe der Erfindung ist es daher, ausgehend von der bekannten Federplatte, eine noch weiter verbesserte Gleichmäßigkeit in der Druckübertragung bei einer Spannanordnung zu ermöglichen.

Die Aufgabe wird erfindungsgemäß durch eine Wellplatte mit einem wellenförmigen Querschnitt für eine Spannanordnung zum Verspannen von Halbleiterbauelementen erreicht, wobei in der Mitte der Wellplatte der wellenförmige Querschnitt eine erste Wellenlänge aufweist und im Außenbereich der Wellplatte der wellenförmige Querschnitt eine zweite Wellenlänge aufweist, wobei die zweite Wellenlänge kürzer ist als die erste Wellenlänge, so dass die Steifigkeit der Wellplatte in ihrer Mitte geringer ist als im Außenbereich. Die Wellenlänge im Sinne der Erfindung ist dabei ein Abstand zwischen zwei benachbarten Wellenbergen oder Wellentälern, der sich bei Ansicht eines Querschnitts der Wellenplatte ergibt, wenn der Querschnitt horizontal ausgerichtet wird. Je größer die Wellenlänge ist, desto leicht kann die Wellplatte eingedrückt werden bzw. desto nachgiebiger ist sie.

Ein wellenförmiger Querschnitt in Sinne der Erfindung kann eine sinusförmige Welle sein. Der wellenförmige Querschnitt kann aber auch nach Art von Sägezähnen mit spitz verlaufenden Tälern und Bergen verlaufen, mithin eher eine dreieckige Form aufweisen. Auch ein rein rechteckiges Querschnittsmuster kann mit Vorteil eingesetzt werden.

Als Material für die Wellplatte kann beispielsweise ein Metall eingesetzt werden.

In einer bevorzugten Ausführungsform der erfindungsgemäßen Wellplatte ist die Wellplatte derart ausgebildet, dass bei Einwirkung einer mechanischen Druckkraft mit vorher festgelegter Stärke, wobei die Druckkraft auf die Mitte der Wellplatte am stärksten einwirkt, die Wellplatte auf der dem Druckstück abgewandten Seite eine im Wesentlichen gleichmäßige Druckkraft weitergibt. Die auf die Wellplatte ausgeübte Druckkraft liegt derzeit häufig bei einer Gewichtskraft von 12 Tonnen bis 16 Tonnen. Zukünftig sind jedoch weitaus größere Druckkräfte absehbar, die z.B. zwischen 10 Tonnen bis 100 Tonnen liegen.

Dies ist ein Vorteil, weil die gleichmäßige Kraftübertragung besonders schonend gegenüber einer bruchempfindlichen Schicht ist, die auf die Wellplatte gepresst wird. Materialschäden können so vermieden werden.

In einer weiteren bevorzugten Ausführungsform der erfindungsgemäßen Wellplatte ist der wellenförmige Querschnitt mittels konzentrischer Ringe um den Mittelpunkt der Wellplatte ausgebildet. Dies ist ein Vorteil, weil eine solche Wellplatte besonders gleichförmig ausgebildet ist und vergleichsweise einfach herzustellen. Die Wellplatte kann dabei scheibenförmig sein, so dass der äußerste Rand z.B. durch ein Wellental einheitlich ausgebildet ist. Wird eine andere Grundform der Wellplatte verwendet, beispielsweise eine quadratische Grundform, so können die äußersten Ringe durch die vier Kanten unterbrochen werden. Ein andere Möglichkeit besteht darin, die Ringe von innen nach außen laufend in ihrer Ausprägung immer mehr von rund nach viereckig zu verändern, so dass am äußersten Rand wiederrum z.B. ein Wellental einen einheitlichen Rand ausbildet.

In einer weiteren bevorzugten Ausführungsform der erfindungsgemäßen Wellplatte ist die Wellplatte in mehrere Bereiche unterteilt, die im Mittelpunkt der Wellplatte zusammentreffen, wobei Wellenkämme und Wellentäler des wellenförmigen Querschnitts in jedem Bereich parallel zu einer Seitenkante des jeweiligen Bereichs verlaufen. Dies besonders bei einer rechteckigen Grundform der Wellplatte von Vorteil, weil z.B. vier Bereiche gebildet werden können, die jeweils ein parallel verlaufendes Wellenmuster aufweisen. Diese Bauform ist vergleichsweise einfach herzustellen. Auch eine dreieckige Bauform ist in dieser Ausführungsform problemlos möglich.

In einer weiteren bevorzugten Ausführungsform der erfindungsgemäßen Wellplatte ist die Wellplatte im Wesentlichen quadratisch ausgebildet und weist vier Bereiche auf, die im Mittelpunkt der Wellplatte zusammentreffen, so dass jeder Bereich ein Dreieck bildet.

In einer weiteren bevorzugten Ausführungsform der erfindungsgemäßen Wellplatte sind Wellentäler und Wellenkämme des wellenförmigen Querschnitts an Kontaktlinien der Bereiche jeweils derart verbunden, dass die Krümmungsradien der Verbindungsstellen von innen nach außen hin auf der Wellplatte kleiner sind, so dass die Steifigkeit der Wellplatte außen größer ist als Innen. Diese Bauform hat den Vorteil, dass mittels der Festlegung der Krümmungsradien die Steifigkeit und damit die Vergleichmäßigung der Druckkraft noch genauer eingestellt werden kann.

In einer weiteren bevorzugten Ausführungsform der erfindungsgemäßen Wellplatte ist die Wellplatte derart ausgebildet, dass der wellenförmige Querschnitt in seiner Wellenlänge von der Mitte der Wellplatte nach außen hin kontinuierlich abnimmt. Dies ist ein Vorteil, weil eine besonders gleichmäßige Weitergabe der Druckkraft erreichbar ist.

Ferner ist eine Aufgabe der Erfindung, eine verbesserte Spannanordnung anzugeben, die kostengünstig herzustellen ist und gleichzeitig eine besonders gleichmäßige Druckverteilung sicherstellt, um Materialschäden zu vermeiden.

Die Erfindung löst diese Aufgabe durch eine Spannanordnung mit einer Spannvorrichtung zum Erzeugen mechanischer Drucckraft auf stapelweise übereinander liegende Schichten, gekennzeichnet durch eine Wellplatte nach einem der Ansprüche 1 bis 7. Mit der erfindungsgemäßen Wellplatte wird der Vorteil erzielt, auch bei einer mehr oder minder punktförmig aufgebrachten Druckkraft zum Zusammenpressen der Schichten eine gleichmäßige Weitergabe des Drucks, d.h. im Wesentlichen mit einem Druck gleicher Höhe über die gesamte Fläche des Wellenprofils, auf empfindliche weitere Schichten mit elektronischen Bauteilen zu erreichen. In der Regel werden alle Schichten so verpresst, dass ein sehr guter elektrischer Kontakt zwischen Ihnen hergestellt wird.

Die Spannanordnung kann beispielsweise in einem Submodul eines modularen Multi-Level Umrichters eingesetzt werden, um eine Reihenschaltung von Leistungshalbleiterschalteinheiten umzusetzen. Die Leistungshalbleiterschalteinheiten weisen jeweils einen ein- und abschaltbaren Leistungshalbleiter mit gleicher Durchlassrichtung auf und sind jeweils entgegen der besagten Durchlassrichtung leitfähig. Weiterhin ist ein dazu in einer Parallelschaltung angeordneten Energiespeicher vorgesehen. Ein solches Submodul ist beispielsweise aus der DE 101 030 31 A1 bekannt.

Durch die Verpressung der Leistungshalbleiterschalteinheiten in den Halbleiterschichten mittels der Wellplatte kann das Risiko einer Beschädigung und damit eines Fehlers der Halbleiter infolge inhomogener Druckverteilung vermindert werden. In einer bevorzugten Ausführungsform der erfindungsgemäßen Spannanordnung ist ein Druckstück zum Übertragen der mechanischen Druckkraft von der Spannvorrichtung auf die stapelweise übereinander liegende Schichten vorgesehen, wobei die Wellplatte zwischen dem Druckstück und den Schichten angeordnet ist. Über das geeignet geformte Druckstück, wobei das Druckstück beispielsweise eine Kegel- oder Trapezform haben kann, ist die Druckkraft von der Spannvorrichtung auf die Bauelemente besonders flächig homogen übertragbar. Geeigneterweise ist die Grundfläche des Druckstücks an die Geometrie der Anordnung angepasst.

In einer weiteren bevorzugten Ausführungsform der erfindungsgemäßen Spannanordnung auf der dem Druckstück abgewandten Seite der Wellplatte eine Kühlvorrichtung als erste Schicht vorgesehen ist. Die Kühlvorrichtung dient zur Ableitung der in den weiteren Schichten angeordneten Halbleiterelemente entstehenden Wärme. Diese Wärme entsteht insbesondere durch den Durchlasswiderstand der Halbleiterelemente. Bevorzugt besteht die Kühlvorrichtung aus einem gut wärmeleitfähigen Material wie beispielsweise Metall oder einer Metalllegierung. Dabei ist die Kühlvorrichtung i.d.R. als eine Platte mit der gleichen Grundform wie alle weiteren Schichten ausgebildet.

In einer weiteren bevorzugten Ausführungsform der erfindungsgemäßen Spannanordnung ist auf der der Wellplatte abgewandten Seite der Kühlvorrichtung eine Halbleiterschicht als zweite Schicht vorgesehen. Es können in der Anordnung auch eine Mehrzahl von Halbleiterschichten vorgesehen sein, wobei jeder der Halbleiterschichten wenigstens eine Kühlvorrichtung zugeordnet ist und die Halbleiterschichten eine elektrische Reihenschaltung ausbilden.

In einer weiteren bevorzugten Ausführungsform der erfindungsgemäßen Spannanordnung sind mindestens eine weitere Kühlvorrichtung und eine weitere Halbleiterschicht vorgesehen. Besonders bevorzugt ist es, wenn jede Halbleiterschicht zwischen zwei Kühlvorrichtungen angeordnet ist. Auf diese Weise kann die Wärmeabfuhr zu beiden Seiten der Halbleiterschicht erfolgen. Da die Kühlvorrichtungen aus leitfähigem Material hergestellt sind, kann die elektrische Kontaktierung zwischen den Halbleiterschichten mittels der Kühlvorrichtungen hergestellt werden. Zur Verbesserung der Druckkraftübertragung auf die Halbleiterschichten kann die Anordnung eine zusätzliche Wellplatte umfassen, die zwischen zwei Kühlvorrichtungen angeordnet ist.

In einer weiteren bevorzugten Ausführungsform der erfindungsgemäßen Spannanordnung ist mindestens eine weitere Wellplatte vorgesehen, die im Stapel der stapelweise übereinander liegenden Schichten eingefügt ist. Dies ist ein Vorteil, weil so auch über die gesamte Länge des Stapels eine Vergleichmäßigung des Anpressdrucks erzielt werden kann.

In einer weiteren bevorzugten Ausführungsform der erfindungsgemäßen Spannanordnung ist mindestens eine Isolierschicht vorgesehen. Die Isolierschicht ist elektrisch nicht leitend ausgebildet und hat den Vorteil, dass durch den Einsatz der Isolierschicht in der Spannanordnung ein Stromfluss durch die Wellplatte verhindert wird.

In einer weiteren bevorzugten Ausführungsform der erfindungsgemäßen Spannanordnung ist die Spannanordnung derart ausgebildet, dass im Betrieb der Spannanordnung die Wellplatte im Wesentlichen stromfrei bleibt. Dies hat den Vorteil, dass eine Hochspannung in der Halbleiterschicht nicht zu einem Stromfluss durch die Wellplatte führt, die i.d.R. metallisch und damit elektrisch leitend ausgeführt ist. Dies kann beispielsweise mit einer Isolierschicht nach der eingangs beschriebenen Ausführungsform erreicht werden.

In einer weiteren bevorzugten Ausführungsform der erfindungsgemäßen Spannanordnung weist die Halbleiterschicht parallel angeordnete Press-Pack-Halbleiter auf, wobei die Halbleiterschicht elektrisch leitend mit der Kühlvorrichtung verbunden ist. Dabei setzt sich die Halbleiterschicht aus nebeneinander angeordneten Halbleitermodulen zusammen. Die Halbleitermodule bilden eine Parallelschaltung von elektrischen Bauteilen. Beispielsweise kann es sich dabei um IGBT-Halbleiter, Dioden oder Thyristorelemente handeln. Die zu verpressende Oberfläche der Bauteile kann je nach Nennspannung und Hersteller beispielsweise zwischen 10x10mm und 18x18mm betragen. Halbleitermodule wie z.B. PressPack IGBT oder Dioden erreichen heute einen Runden Durchmesser von 5 Zoll bzw. zukünftig 6 Zoll in der Gehäusebauform. Auch Presspack Halbleiter mit rechteckigen Außenmaßen sind bekannt. Zukünftige IGBT Halbleiter können aber auch diese bekannten Flächengrößen noch übersteigen.

In einer weiteren bevorzugten Ausführungsform der erfindungsgemäßen Spannanordnung ist ein Gegendruckstück vorgesehen, das an der dem Druckstück gegenüberliegenden Ende der gestapelten Schichten angeordnet ist. Dies ist ein Vorteil, weil auf diese Weise ein besonders gleichmäßiges Zusammenpressen der Schichten sicher gestellt wird.

In einer weiteren bevorzugten Ausführungsform der erfindungsgemäßen Spannanordnung ist eine ergänzende Wellplatte zwischen dem Gegendruckstück und den Schichten angeordnet. Dies ist ein Vorteil, weil auf diese Weise ein besonders gleichmäßiges Zusammenpressen der Schichten sicher gestellt wird.

Die Erfindung wird nachfolgend anhand der in Figuren 1 bis 3 dargestellten Ausführungsbeispiele näher erläutert.
- Figur 1: zeigt ein Ausführungsbeispiel einer erfindungsgemäßen Wellplatte in einer schematischen Darstellung als Draufsicht, und
- Figur 2: zeigt einen Querschnitt durch die Wellplatte gemäß Figur 1, und
- Figur 3: zeigt einen Querschnitt durch eine erfindungsgemäße Spannanordnung.

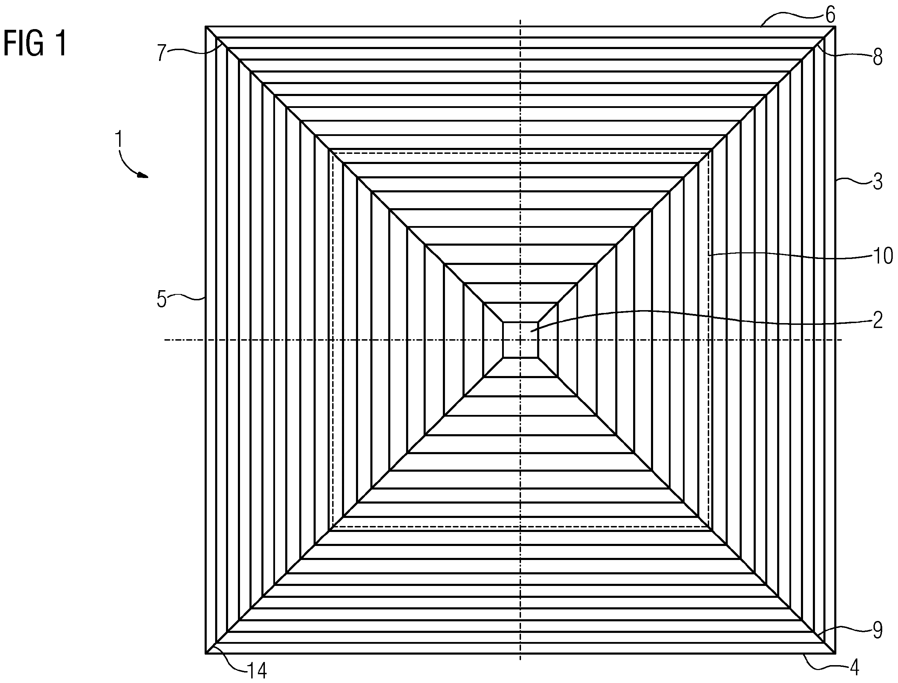

Die Figur 1 zeigt eine Draufsicht auf eine erfindungsgemäße Wellplatte 1. Die Wellplatte 1 weist in ihrer Mitte 2 einen flachen Bereich auf, der kein Wellenprofil aufweist. In diesem Bereich wird folglich keine Kraft durch die Wellplatte 1 übertragen. An die Mitte 2 schließt sich ein innerer Bereich an, der durch das gestrichelte Kästchen 10 angedeutet ist. In diesem inneren Bereich weist der wellenförmige Querschnitt eine erste Wellenlänge auf. Außerhalb des Kästchens 10 ist ein zweiter Bereich bis zu den Außenseiten 3, 4, 5, 6 der Wellplatte 1 vorgesehen, in dem der wellenförmige Querschnitt eine zweite Wellenlänge aufweist, die zumindest im Durchschnitt kürzer ist als die erste Wellenlänge. Hieraus ergibt sich eine veränderte Steifigkeit der Wellplatte 1, die im inneren Bereich deutlich weniger steif als in den Außenbereichen ist. Wird nun ein Druck auf die Wellplatte 1 ausgeübt, und zwar in der Form, dass der Druck auf die Mitte 2 am stärksten aufgebracht wird, so wird mittels der unterschiedlichen Wellenlängen der Wellplatte 1 sichergestellt, dass der Druck gleichmäßig weitergegeben wird.

Die Wellplatte 1 weist eine quadratische Grundfläche auf und ist in vier Bereiche unterteilt, die sich durch die Linien 7,8,9,14 ergeben. Die vier Bereiche haben jeweils eine dreieckige Form und treffen im Mittelpunkt 2 der Wellplatte 1 zusammen, wobei Wellenkämme und Wellentäler der wellenförmigen Querschnitte in jedem Bereich parallel zu der jeweiligen Seitenkante 3, 4, 5, 6 des jeweiligen Bereichs verlaufen. An den Verbindungsstellen auf den Linien 7,8,9,14 sind die Wellentäler und Wellenkämme des wellenförmigen Querschnitts derart verbunden, dass die Krümmungsradien der Verbindungsstellen von innen nach außen hin auf der Wellplatte kleiner sind, so dass die Steifigkeit der Wellplatte 1 außen größer ist als innen. Die gezeigte Ausführungsform zeichnet sich dadurch aus, dass eine Vielzahl unterschiedlicher Wellenlängen von innen nach außen vorgesehen wird. Im Idealfall nimmt die Wellenlänge im wellenförmigen Querschnitt von der Mitte 2 der Wellplatte 1 nach außen hin kontinuierlich ab, so dass eine besonders gleichmäßige Druckverteilung sichergestellt ist.

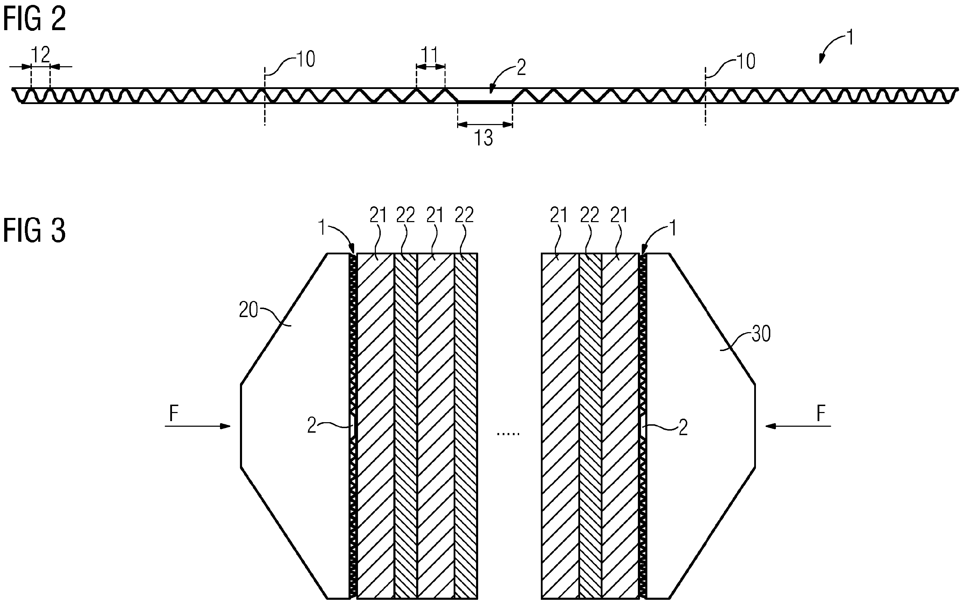

Die Figur 2 zeigt einen Querschnitt durch die Wellenplatte 1 gemäß Figur 1. Gleiche Bauelemente weisen die gleichen Bezugszeichen auf. Beispielhaft ist gezeigt, dass der Abstand 11 zwischen zwei Wellenkämmen im inneren Bereich der Wellplatte 1 deutlich größer ist als zwischen zwei Wellenlängen 12 in einem äußeren Bereich der Wellplatte. Im Inneren der Wellplatte 1 am Mittelpunkt 2 ist deutlich zu erkennen, dass es einen Bereich mit Durchmesser 13 gibt, der kein Wellenprofil aufweist. Wird in diesem Bereich ein besonders hoher Druck auf die Wellplatte 1 ausgeübt, so wird dieser nicht weitergegeben, sondern vielmehr über das wellenförmige Profil des Restes der Wellplatte 1 gleichmäßig weitergegeben.

Die Figur 3 zeigt eine Spannanordnung, die mit mindestens einer nicht gezeigten Spannvorrichtung verspannt ist. Die durch die Spannvorrichtung ausgeübte Kraft ist mit zwei Pfeilen F angedeutet. Von links nach rechts ist zu erkennen, dass zunächst ein trapezförmiges Druckstück 20 vorgesehen ist, welches den vergleichsweise punktuell auftretenden Druck F auf eine größere Fläche verteilt. Im dreidimensionalen Raum wäre das Druckstück beispielsweise als ein Pyramidenstumpf mit quadratischer Grundfläche ausgebildet, wobei auf der Grundfläche eine erfindungsgemäße Wellplatte 1 gemäß Figur 1 angeordnet ist.

Als nächste Schicht schließt sich eine Kühlvorrichtung 21 an, auf die eine Halbleiterschicht 22 folgt. Es können auch Isolierschichten (nicht dargestellt) in der Spannanordnung vorgesehen sein, die z.B. wiederum mittels einer Wellplatte angepresst wird. Die Wellplatte muss dabei immer so positioniert sein, dass sie nicht stromdurchflossen ist.

Es folgen durch drei Punkte angedeutete weitere Abfolgen von Kühlvorrichtungen 21 und Halbleiterschichten 22, so dass jede Halbleiterschicht 22 von zwei Kühlplatten 21 eingefasst ist. Dies hat den Vorteil, dass Wärme beidseitig von den Halbleiterschichten abgeführt werden kann. Auf der gegenüberliegenden Seite wiederholt sich der Aufbau derart, dass eine Wellplatte 1 auf ein Gegendruckstück 20 trifft, welches in Verbindung mit dem ersten Druckstück ein gleichmäßiges Zusammenpressen der gesamten Spannanordnung gewährleistet.

## Patentansprüche

1. Wellplatte (1) mit einem wellenförmigen Querschnitt für eine Spannanordnung zum Verspannen von HalbleiterBauelementen, **dadurch gekennzeichnet, dass**
in der Mitte der Wellplatte (1) der wellenförmige Querschnitt eine erste Wellenlänge aufweist, und
im Außenbereich der Wellplatte (1) der wellenförmige Querschnitt eine zweite Wellenlänge aufweist,
wobei die zweite Wellenlänge kürzer ist als die erste Wellenlänge, so dass die Steifigkeit der Wellplatte (1) in ihrer Mitte geringer ist als im Außenbereich.

2. Wellplatte (1) nach Anspruch 1, **dadurch gekennzeichnet, dass** die Wellplatte (1) derart ausgebildet ist, dass bei Einwirkung einer mechanischen Druckkraft mit vorher festgelegter Stärke, wobei die Druckkraft auf die Mitte der Wellplatte (1) am Stärksten einwirkt, die Wellplatte (1) auf der der Drucckraft abgewandten Seite eine im Wesentlichen gleichmäßige Druckkraft weitergibt.

3. Wellplatte (1) nach Anspruch 1 oder 2, **dadurch gekennzeichnet, dass** der Wellenförmige Querschnitt mittels konzentrischer Ringe um den Mittelpunkt der Wellplatte (1) ausgebildet ist.

4. Wellplatte (1) nach Anspruch 1 oder 2, **dadurch gekennzeichnet, dass** die Wellplatte (1) in mehrere Bereiche unterteilt ist, die im Mittelpunkt (2) der Wellplatte (1) zusammentreffen, wobei Wellenkämme und Wellentäler des wellenförmigen Querschnitts in jedem Bereich parallel zu einer Seitenkante (3,4,5,6) des jeweiligen Bereichs verlaufen.

5. Wellplatte (1) nach Anspruch 4, **dadurch gekennzeichnet, dass** die Wellplatte (1) im Wesentlichen quadratisch ausgebildet ist und vier Bereiche aufweist, die im Mittelpunkt der Wellplatte (1) zusammentreffen, so dass jeder Bereich ein Dreieck bildet.

6. Wellplatte (1) nach Anspruch 4 oder 5, **dadurch gekennzeichnet, dass** Wellentäler und Wellenkämme des wellenförmigen Querschnitts an Kontaktlinien (7,8,9,14) der Bereiche derart verbunden sind, dass die Krümmungsradien der Verbindungsstellen von innen nach außen hin kleiner sind, so dass die Steifigkeit der Wellplatte (1) außen größer ist als Innen.

7. Wellplatte (1) nach einem der vorhergehenden Ansprüche, **dadurch gekennzeichnet, dass** die Wellplatte (1) derart ausgebildet ist, dass der wellenförmige Querschnitt in seiner Wellenlänge von der Mitte der Wellplatte (1) nach außen hin kontinuierlich abnimmt.

8. Spannanordnung mit einer Spannvorrichtung zum Erzeugen mechanischer Druckkraft auf stapelweise übereinander liegende Schichten (21,22), **gekennzeichnet durch** eine Wellplatte (1) nach einem der Ansprüche 1 bis 7.

9. Spannanordnung nach Anspruch 8, **dadurch gekennzeichnet, dass** ein Druckstück (20) zum Übertragen einer mechanischen Druckkraft (F) von der Spannvorrichtung auf die stapelweise übereinander liegenden Schichten (21,22) vorgesehen ist, wobei die Wellplatte (1) zwischen dem Druckstück (20) und den Schichten (21,22) angeordnet ist.

10. Spannanordnung nach Anspruch 9, **dadurch gekennzeichnet, dass** auf der dem Druckstück (20) abgewandten Seite der Wellplatte (1) eine Kühlvorrichtung (21) als erste Schicht vorgesehen ist.

11. Spannanordnung nach Anspruch 10, **dadurch gekennzeichnet, dass** auf der der Wellplatte (1) abgewandten Seite der Kühlvorrichtung (21) eine Halbleiterschicht (22) als zweite Schicht vorgesehen ist.

12. Spannanordnung nach Anspruch 11, **dadurch gekennzeichnet, dass** mindestens eine weitere Kühlvorrichtung (21) und eine weitere Halbleiterschicht (22) vorgesehen sind.

13. Spannanordnung nach Anspruch 11 oder 12, **dadurch gekennzeichnet, dass** die Halbleiterschicht (22) parallel angeordnete Press-Pack-Halbleiter aufweist, wobei die Halbleiterschicht (22) elektrisch leitend mit der Kühlvorrichtung (21) verbunden ist.

14. Spannanordnung nach einem der Ansprüche 9 bis 13, **dadurch gekennzeichnet, dass** ein Gegendruckstück (30) vorgesehen ist, das an dem dem Druckstück (20) gegenüberliegenden Ende der gestapelten Schichten (21,22) angeordnet ist.

15. Spannanordnung nach Anspruch 14, **dadurch gekennzeichnet, dass** eine ergänzende Wellplatte (1) zwischen dem Gegendruckstück (30) und den Schichten (21,22) angeordnet ist.

## Claims

1. Corrugated panel (1) with a wave-shaped cross section for a clamping arrangement for clamping semiconductor components, **characterized in that**
the wave-shaped cross section has a first wavelength in the centre of the corrugated panel (1), and
the wave-shaped cross section has a second wavelength in the outer region of the corrugated panel (1),
wherein the second wavelength is shorter than the first wavelength, so that the stiffness of the corrugated panel (1) is lower in its centre than in the outer region.

2. Corrugated panel (1) according to Claim 1, **characterized in that** the corrugated panel (1) is designed in such a way that, in the event of action of a mechanical pressure force with a predefined intensity, wherein the pressure force acts most strongly on the centre of the corrugated panel (1), the corrugated panel (1) passes on a substantially uniform pressure force to the side averted from the pressure force.

3. Corrugated panel (1) according to Claim 1 or 2, **characterized in that** the wave-shaped cross section is formed by means of concentric rings around the centre point of the corrugated panel (1).

4. Corrugated panel (1) according to Claim 1 or 2, **characterized in that** the corrugated panel (1) is subdivided into several regions which meet at the centre point (2) of the corrugated panel (1), wherein wave crests and wave troughs of the wave-shaped cross section in each region run parallel to a side edge (3, 4, 5, 6) of the respective region.

5. Corrugated panel (1) according to Claim 4, **characterized in that** the corrugated panel (1) is of substantially square design and has four regions which meet at the centre point of the corrugated panel (1), so that each region forms a triangle.

6. Corrugated panel (1) according to Claim 4 or 5, **characterized in that** wave troughs and wave peaks of the wave-shaped cross section are connected at contact lines (7, 8, 9, 14) of the regions in such a way that the radii of curvature of the connecting points are smaller from the inside to the outside, so that the stiffness of the corrugated panel (1) is greater on the outside than in the interior.

7. Corrugated panel (1) according to one of the preceding claims, **characterized in that** the corrugated panel (1) is designed in such a way that the wavelength of the wave-shaped cross section decreases continuously from the centre of the corrugated panel (1) to the outside.

8. Clamping arrangement comprising a clamping apparatus for generating mechanical pressure force on layers (21, 22) situated one above the other in a stacked manner, **characterized by** a corrugated panel (1) according to one of Claims 1 to 7.

9. Clamping arrangement according to Claim 8, **characterized in that** a pressure piece (20) for transmitting a mechanical pressure force (F) from the clamping apparatus onto the layers (21, 22) situated one above the other in a stacked manner is provided, wherein the corrugated panel (1) is arranged between the pressure piece (20) and the layers (21, 22).

10. Clamping arrangement according to Claim 9, **characterized in that** a cooling apparatus (21) is provided as a first layer on the side of the corrugated panel (1) that is averted from the pressure piece (20).

11. Clamping apparatus according to Claim 10, **characterized in that** a semiconductor layer (22) is provided as a second layer on the side of the cooling apparatus (21) that is averted from the corrugated panel (1).

12. Clamping arrangement according to Claim 11, **characterized in that** at least one further cooling apparatus (21) and one further semiconductor layer (22) are provided.

13. Clamping arrangement according to Claim 11 or 12, **characterized in that** the semiconductor layer (22) has press-pack semiconductors arranged in parallel, wherein the semiconductor layer (22) is electrically conductively connected to the cooling apparatus (21).

14. Clamping arrangement according to one of Claims 9 to 13, **characterized in that** a mating pressure piece (30) is provided which is arranged at the end of the stacked layers (21, 22) that is situated opposite the pressure piece (20).

15. Clamping arrangement according to Claim 14, **characterized in that** a supplementary corrugated panel (1) is arranged between the mating pressure piece (30) and the layers (21, 22) .

## Revendications

1. Plaque (1) ondulée ayant une section transversale ondulée pour un agencement de serrage pour le blocage de composants à semi-conducteurs, **caractérisée en ce que**
au milieu de la plaque (1) ondulée, la section transversale ondulée a une première longueur d'ondulation et,
dans la partie extérieure de la plaque (1) ondulée, la section transversale ondulée a une deuxième longueur d'ondulation,
dans laquelle la deuxième longueur d'ondulation est plus courte que la première longueur d'ondulation, de sorte que la rigidité de la plaque (1) ondulée est plus petite au milieu que dans la partie extérieure.

2. Plaque (1) ondulée suivant la revendication 1, **caractérisée en ce que** la plaque (1) ondulée est constituée de manière à ce que, lorsqu'une force de pression mécanique s'applique à une intensité fixée à l'avance la force de pression s'applique le plus intensément au milieu de la plaque (1) ondulée, la plaque (1) ondulée redonnant une force de pression sensiblement uniforme sur la face éloignée de la force de pression.

3. Plaque (1) ondulée suivant la revendication 1 ou 2, **caractérisée en ce que** la section transversale ondulée est constituée au moyen d'anneaux concentriques autour du centre la plaque (1) ondulée.

4. Plaque (1) ondulée suivant la revendication 1 ou 2, **caractérisée en ce que** la plaque (1) ondulée est subdivisée en plusieurs parties, qui se rencontrent au centre (2) de la plaque (1) ondulée, des crêtes d'ondulation et des creux d'ondulation de la section transversale ondulée s'étendant dans chaque partie parallèlement à un bord (3, 4, 5, 6) latéral de la partie respective.

5. Plaque (1) ondulée suivant la revendication 4, **caractérisée en ce que** la plaque (1) ondulée est constituée de manière sensiblement carrée et a quatre parties, qui se rencontrent au centre la plaque (1) ondulée de sorte que chaque partie forme un triangle.

6. Plaque (1) ondulée suivant la revendication 4 ou 5, **caractérisée en ce que** les creux d'ondulation et les crêtes d'ondulation de la section transversale ondulée sont reliées sur des lignes (7, 8, 9, 14) de contact des parties, de manière à ce que les rayons de courbure des points de liaisons soient plus petits de l'intérieur vers l'extérieur de sorte que la rigidité de la plaque (1) ondulée est plus grande à l'extérieur qu'à l'intérieur.

7. Plaque (1) ondulée suivant l'une des revendications précédentes, **caractérisée en ce que** la plaque (1) ondulée est constituée de manière à ce que la longueur d'ondulation de la section transversale ondulée diminue continuellement du milieu de la plaque (1) ondulée à l'extérieur.

8. Agencement de serrage ayant un système de serrage pour la production d'une force de pression mécanique sur des couches (21, 22) superposées à la manière d'un empilement, **caractérisé par** une plaque (1) ondulée suivant l'une des revendications 1 à 7.

9. Agencement de serrage suivant la revendication 8, **caractérisé en ce qu'**il est prévu une pièce (20) d'application d'une pression pour la transmission d'une force (F) de pression mécanique du système de serrage aux couches (21, 22) superposées à la manière d'un empilement, la plaque (1) ondulée étant disposée entre la pièce (20) d'application d'une pression et les couches (21, 22).

10. Agencement de serrage suivant la revendication 9, **caractérisé en ce qu'**il est prévu, comme première couche, un système (21) de refroidissement sur la face de la plaque (1) ondulée loin de la pièce (20) d'application d'une pression.

11. Agencement de serrage suivant la revendication 10, **caractérisé en ce qu'**il est prévu, comme deuxième couche, une couche (22) à semi-conducteurs sur la face du système (21) de refroidissement loin de la plaque (1) ondulée.

12. Agencement de serrage suivant la revendication 11, **caractérisé en ce qu'**il est prévu au moins un autre système (21) de refroidissement et une autre couche (22) à semi-conducteurs.

13. Agencement de serrage suivant la revendication 11 ou 12, **caractérisé en ce que** la couche (22) à semi-conducteurs a des semi-conducteurs press-pack montés en parallèle, la couche (22) à semi-conducteurs étant reliée d'une manière conductrice de l'électricité au système (21) de refroidissement.

14. Agencement de serrage suivant l'une des revendications 9 à 13, **caractérisé en ce qu'**il est prévu une pièce (30) de contrepression, qui est disposée à l'extrémité, opposée à la pièce (20) d'application d'une pression, des couches (21, 22) empilées.

15. Agencement de serrage suivant la revendication 14, **caractérisé en ce qu'**une plaque (1) ondulée de complément est disposée entre la pièce (30) de contrepression et les couches (21,22).
